# EUROPÄISCHE PATENTSCHRIFT

(11) **EP 3 537 117 B1**
(45) Veröffentlichungstag und Bekanntmachung des Hinweises auf die Patenterteilung: **11.11.2020**
(21) Anmeldenummer: 18160361.4
(22) Anmeldetag: 06.03.2018
(51) Int. Cl.: G01H 11/08, B06B 1/06, H01L 41/25, H01L 41/053, H01L 41/083

(54) **PIEZOELEKTRISCHE SENDE- UND/ODER EMPFANGSEINRICHTUNG FÜR EINEN VIBRATIONSSENSOR, VIBRATIONSSENSOR MIT EINER SOLCHEN PIEZOELEKTRISCHEN SENDE- UND/ODER EMPFANGSEINRICHTUNG SOWIE VERFAHREN ZUR HERSTELLUNG EINER PIEZOELEKTRISCHEN SENDE- UND/ODER EMPFANGSEINRICHTUNG FÜR EINEN VIBRATIONSSENSOR**
PIEZOELECTRIC TRANSMITTING AND/OR RECEIVING DEVICE FOR A VIBRATION SENSOR, VIBRATION SENSOR HAVING SUCH A PIEZOELECTRIC TRANSMITTING AND/OR RECEIVING DEVICE AND METHOD FOR MANUFACTURING A PIEZOELECTRIC TRANSMITTING AND/OR RECEIVING DEVICE FOR A VIBRATION SENSOR
DISPOSITIF D'ÉMISSION ET/OU DE RÉCEPTION PIÉZOÉLECTRIQUE POUR UN CAPTEUR DE VIBRATION, CAPTEUR DE VIBRATION POURVU D'UN TEL DISPOSITIF D'ÉMISSION ET/OU DE RÉCEPTION PIÉZOÉLECTRIQUE AINSI QUE PROCÉDÉ DE FABRICATION D'UN DISPOSITIF D'ÉMISSION ET/OU DE RÉCEPTION PIÉZOÉLECTRIQUE POUR UN CAPTEUR DE VIBRATION

(43) Veröffentlichungstag der Anmeldung: 11.09.2019
(73) Patentinhaber: VEGA Grieshaber KG, 77709 Wolfach (DE)
(72) Erfinder: Fehrenbach, Dominik, 78628 Rottweil (DE); Allgaier, Volker, 77716 Haslach i. K. (DE)
(74) Vertreter: Patentanwälte Bauer Vorberg Kayser

(56) Entgegenhaltungen:
- EP-A1- 1 909 078
- DE-A1-102016 108 553
- JP-B2- 5 288 719

## Beschreibung

Die vorliegende Erfindung betrifft eine piezoelektrische Sende- und/oder Empfangseinrichtung für einen Vibrationssensor gemäß dem Oberbegriff des Patentanspruchs 1, einen Vibrationssensor mit einer solchen piezoelektrischen Sende- und/oder Empfangseinrichtung gemäß Patentanspruch 9 sowie ein Verfahren zur Herstellung einer piezoelektrischen Sende- und/oder Empfangseinrichtung gemäß Patentanspruch 10.

Aus dem Stand der Technik sind piezoelektrische Sende- und/oder Empfangseinrichtungen, Vibrationssensoren mit solchem piezoelektrischen Sende- und/oder Empfangseinrichtungen, sowie Verfahren zur Herstellung von piezoelektrischen Sende- und/oder Empfangseinrichtungen bekannt. Piezoelektrische Sende- und/oder Empfangseinrichtungen können beispielsweise in Vibrationssensoren, die häufig in der Füllstandmesstechnik als Grenzstandsensoren zum Einsatz kommen, als Sende- und/oder Empfangseinrichtung eingesetzt werden. Häufig werden solche piezoelektrischen Sende- und/oder Empfangseinrichtungen auch als Antrieb bezeichnet.

Typischerweise weist der Vibrationssensor eine über einen solchen Antrieb zu einer Schwingung anregbare Membran auf, mittels der ein an der Membran angeordneter mechanischer Schwinger zu einer Schwingung anregbar ist. Abhängig von einem Bedeckungsstand des mechanischen Schwingers mit einem Füllgut sowie abhängig von der Viskosität dieses Füllgutes schwingt der mechanische Schwinger mit einer charakteristischen Frequenz, die von dem Vibrationssensor detektiert werden und in ein Messsignal umgewandelt werden kann.

Im Stand der Technik sind zwei unterschiedliche Arten von Antrieben häufig im Einsatz. In einer ersten Variante ist ein mehrfach segmentiertes Piezoelement mit der Membran verklebt. Durch Anlegen einer elektrischen Spannung an einzelne oder mehrere Segmente des Piezoelements wird dieses zu einer Biegung oder Torsion angeregt und überträgt diese auf die Membran, die dadurch in Schwingung versetzt wird und den mechanischen Schwinger in Schwingung versetzt. Diese Art von Antrieb erzeugt nur einen begrenzten Hub und kann nur bei Vibrationssensoren eingesetzt werden, die bei Temperaturen unter der Glasübergangstemperatur des verwendeten Klebers und unterhalb der Curie-Temperatur des verwendeten Piezomaterials eingesetzt werden. Für Hochtemperaturanwendungen über 150°C sind diese Sensoren nicht geeignet.

Wird für eine Anwendung ein Sensor mit größerem Hub benötigt oder ist ein Einsatz bei höheren Temperaturen notwendig, so wird eine zweite Variante von Antrieben, sogenannte Piezostapelantriebe, eingesetzt.

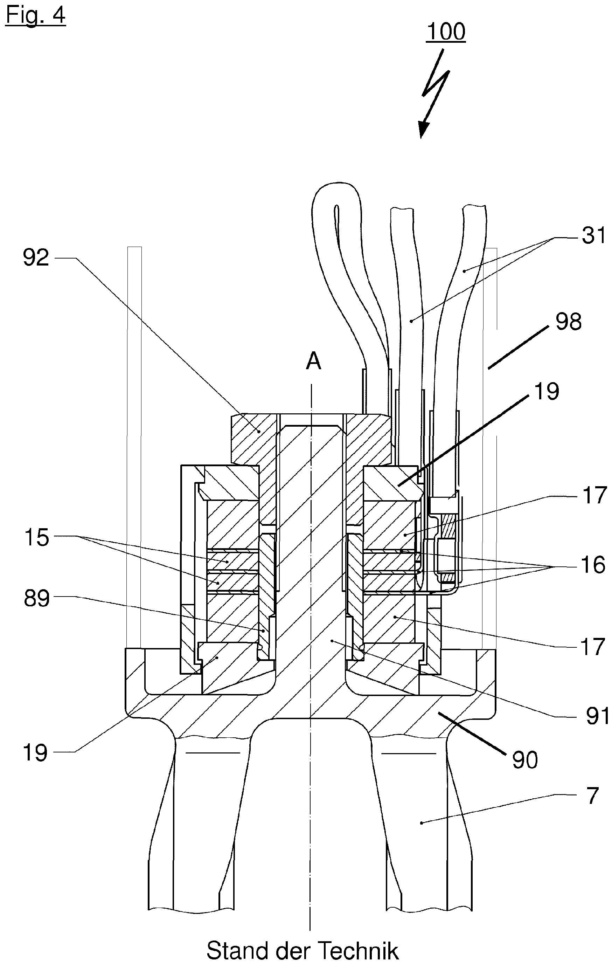

Hier ist ein Stapel aus einer Piezoeinheit aus einem oder mehreren Piezoelementen, je einer oberhalb und unterhalb der Piezoeinheit angeordneten Anpassungskeramik sowie oberhalb und unterhalb der Anpassungskeramiken angeordneten Druckstücken über einem an der Membran des Sensors angeordneten Spannbolzen und eine Spannmutter gegen die Membran gespannt. Durch Anlegen einer elektrischen Spannung an die Piezoelemente ändern diese ihre Ausdehnung in Axialrichtung des Bolzens und versetzen die Membran so in Schwingung. Ein bekannter Vibrationssensor mit einem Piezostapelantrieb ist in Figur 4 gezeigt.

Figur 4 zeigt einen Ausschnitt eines aus dem Stand der Technik bekannten Vibrationssensors 100, der beispielsweise in der Füllstandmesstechnik als Grenzstandsensor eingesetzt wird.

Die piezoelektrische Sende- und/oder Empfangseinrichtung 1 ist über einen an der Membran 90 einstückig angeformten Spannbolzen 91 mittels einer Spannmutter 92 gegen die Membran 90 verspannt, sodass Schwingungen der piezoelektrischen Sende- und/oder Empfangseinrichtung 1 effektiv auf die Membran 90 übertragen werden und umgekehrt. Die Elektroden 16 zur Kontaktierung der Piezoelemente 15 sind mit Anschlussleitungen 31 kontaktiert, die außenseitig an dem Piezostapelantrieb 11 verlaufen und rückseitig zu einer Sensorelektronik geführt sind. An der Membran 90 ist über einen außenseitig umlaufenden und sich in rückseitige Richtung erstreckenden Rand ein Sensorgehäuse 98 angeordnet, das mit dem Rand der Membran 90 verbunden oder einstückig mit diesem ausgebildet ist.

Der Vibrationssensor 100 weist einen Piezostapelantrieb 11 aus übereinander gestapelten über Elektroden 16 kontaktierten Piezoelementen 15 auf, wobei oberhalb und unterhalb in dem Stapel je eine Anpassungskeramik 17 sowie ein Druckstück 19, vorliegend aus einem metallischen Werkstoff, angeordnet ist. Die Anpassungskeramiken 17 dienen zur Anpassung eines thermischen Ausdehnungskoeffizienten zwischen den Piezoelementen 15 und den Druckstücken 19. Die Druckstücke 19 sind derart ausgebildet, dass eine Kraftwirkung aus dem Piezostapel vollflächig abgegriffen wird.

Der Vibrationssensor 100 weist eine über eine piezoelektrische Sende- und/oder Empfangseinrichtung 1 zu einer Schwingung anregbare Membran 90 auf, mittels der ein an der Membran 90 angeordnete mechanische Schwingungseinheit 7 zu einer Schwingung anregbar ist.

Bei beschichteten Vibrationssensoren, die beispielsweise für Anwendungen in Säure, Öl, Gas und der Petrochemie eingesetzt werden, werden für den Beschichtungsvorgang Temperaturen in einem Bereich von über 400°C erreicht. Diese Temperaturen liegen über der Curie-Temperatur der eingesetzten Piezoelemente, sodass die piezoelektrische Sende- und/oder Empfangseinrichtung erst nach einem Beschichtungsvorgang eingebaut werden kann.

Ferner muss der Vibrationssensor 100 mit eingebautem und vorgespanntem Antrieb 1 getempert und anschließend die Spannmutter 92 nachgezogen werden. Ohne diesen Arbeitsschritt ist eine korrekte Funktion der piezoelektrischen Sende- und/oder Empfangseinrichtung 1 nicht gewährleistet, da eine ausreichende Vorspannung nicht gegeben ist und durch thermische Einflüsse ein sich Setzen des Antriebs 1 dann erst im Betrieb beim Anwender stattfinden würde.

Dieses Tempern des fertig montierten Vibrationssensors 100 ist insbesondere bei sogenannten Rohrversionen, bei denen der Vibrationssensor durch eine Rohrverlängerung in einem größeren Abstand von einer Behälteroberseite angebracht werden kann sehr aufwendig, da diese Rohrversionen Längen von bis zu 6 m aufweisen können. Diese können nur sehr schwierig in einem Temperofen eingebracht werden.

Bekannte Vibrationssensoren sind aus der EP 1 909 078 A1 und der DE 10 2016 108 533 A1 der Anmelderin bekannt.

Es ist die Aufgabe der vorliegenden Erfindung eine piezoelektrische Sende- und/oder Empfangseinrichtung für einen Vibrationssensor, einen Vibrationssensor mit einer solchen piezoelektrischen Sende- und/oder Empfangseinrichtung sowie ein Verfahren zur Herstellung einer piezoelektrischen Sende- und/oder Empfangseinrichtung für einen Vibrationssensor derart weiterzubilden, dass eine universelle Einsetzbarkeit der piezoelektrischen Sende- und/oder Empfangseinrichtung sowie eine vereinfachte Montage möglich ist.

Diese Aufgabe wird durch eine piezoelektrische Sende- und/oder Empfangseinrichtung mit den Merkmalen des Patentanspruchs 1, einen Vibrationssensor mit einer solchen piezoelektrischen Sende- und/oder Empfangseinrichtung gemäß Patentanspruch 7 sowie ein Verfahren zum Herstellen einer piezoelektrischen Sende- und/oder Empfangseinrichtung mit den Merkmalen des Patentanspruchs 8 gelöst. Vorteilhafte Weiterbildungen sind in abhängigen Patentansprüchen angegeben.

Eine erfindungsgemäße piezoelektrische Sende- und/oder Empfangseinrichtung für einen Vibrationssensor zeichnet sich dadurch aus, dass die piezoelektrische Sende- und/oder Empfangseinrichtung als separat handhabbare Einheit mit einer Antriebsaufnahme mit einem mechanischen Verbindungsabschnitt zum Verbinden der piezoelektrischen Sende- und/oder Empfangseinrichtung mit einer Membran des Vibrationssensors ausgebildet ist.

Dadurch, dass die piezoelektrische Sende- und/oder Empfangseinrichtung, die nachfolgend auch als Antrieb bezeichnet wird, als separat handhabbare Einheit ausgebildet ist, kann diese separat vormontiert, vorgespannt, getempert und nachgezogen werden und anschließend über ihren mechanischen Verbindungsabschnitt mit der Membran des Vibrationssensors verbunden, d. h. derart in ein Sensorgehäuse eingesetzt werden, dass mechanische Schwingungen der piezoelektrischen Sende- und/oder Empfangseinrichtung auf die Membran übertragen werden und umgekehrt. Die erfindungsgemäße Ausgestaltung hat damit den Vorteil, dass die piezoelektrische Sende- und/oder Empfangseinrichtung unabhängig davon, ob es sich um einen beschichteten Vibrationssensor oder einen Vibrationssensor mit einer Rohrverlängerung handelt zu einem geeigneten Zeitpunkt im Montageprozess in diesen eingesetzt werden kann. Zusätzliche Temperschritte nach einer Montage des Antriebs sind nicht notwendig.

Die Antriebsaufnahme weist erfindungsgemäß einen Befestigungsabschnitt zum Befestigen und Vorspannen eines Piezostapelantriebs in der Antriebsaufnahme auf. Durch einen geeignet dimensionierten Befestigungsabschnitt kann der Piezostapelantrieb auf diese Weise an oder in der Antriebsaufnahme vormontiert, vorgespannt, getempert und nachgezogen werden. Das hat den Vorteil, dass die piezoelektrischen Sende- und/oder Empfangseinrichtungen separat vorgefertigt und einsatzbereit vormontiert werden können. Durch einen geeignet dimensionierten Befestigungsabschnitt, d. h. insbesondere einen hinreichend stabil und verwindungssteif ausgestalteten Befestigungsabschnitt ist der Piezostapelantrieb beispielsweise mittels einer geeigneten Spanneinrichtung, die beispielsweise als Spannschraube ausgestaltet sein kann, vorgespannt.

Der Piezostapelantrieb kann beispielsweise einen Stapel mit einer Piezoeinheit mit wenigstens einem Piezoelement, sowie im Stapel oberhalb und unterhalb der Piezoeinheit jeweils eine Anpassungskeramik zur Angleichung des thermischen Ausdehnungskoeffizienten aufweisen.

Ferner kann in dem Stapel ober- und unterhalb der Anpassungskeramik jeweils ein vorzugsweise metallisches Druckstück angeordnet sein, sodass eine Kraftwirkung aus der Piezoeinheit vollflächig abgegriffen wird. Hierfür können die Druckstücke, die Anpasskeramiken sowie das wenigstens eine Piezoelement mit kreisförmiger Außenkontur und identischem Durchmesser ausgebildet sein.

Vorteilhafterweise kann der Piezostapelantrieb zu einem Monoblock gesintert sein. Dies hat den Vorteil, dass durch das Sintern des Antriebs kompaktere Antriebe erreicht werden können, da die einzelnen Piezoelemente beispielsweise über eine elektrisch leitende Sinterpaste auf Silberbasis miteinander verbunden und gleichzeitig elektrisch kontaktiert werden können.

Um diese zu erleichtern, können die Piezoelemente jeweils eine Nut aufweisen, in der eine Anschlussleitung zur Kontaktierung der Piezoelemente angeordnet ist und auf diese Weise mit in den Monoblock integriert werden kann. Auf diese Weise kann der Aufwand zur elektrischen Kontaktierung die piezoelektrischen Sende- und/oder Empfangseinrichtung noch weiter reduziert werden.

Die Nuten können an radial gegenüberliegenden Seiten auf einer Seite oberseitig und auf der anderen Seite unterseitig im Piezoelement angeordnet sein. Die Nuten können in Radialrichtung verlaufend ausgebildet sein, aber auch quer dazu verlaufen.

Der zu einem Monoblock gesinterte Piezostapelantrieb kann insbesondere nicht nur die Piezoelemente, sondern auch die Anpasskeramiken und die Druckstücke mit umfassen, sodass eine kompakte und separat handhabbare Einheit geschaffen wird.
Ein erfindungsgemäßer Vibrationssensor mit einer an einer in Schwingung versetzbaren Membran angeordneten mechanischen Schwingungseinheit weist einen zweiten Verbindungsabschnitt zum Verbinden der Membran mit einer piezoelektrischen Sende- und/oder Empfangseinrichtung derart auf, dass Schwingungen der piezoelektrischen Sende- und/oder Empfangseinrichtung auf die Membran und Schwingungen der Membran auf die piezoelektrische Sende- und/oder Empfangseinrichtung übertragen werden, wobei die piezoelektrische Sende- und/oder Empfangseinrichtung als separat handhabbare Einheit gemäß der obigen Beschreibung ausgebildet ist.

Ein erfindungsgemäßes Verfahren zum Herstellen der zuvor beschriebenen piezoelektrischen Sende- und/oder Empfangseinrichtung für einen Vibrationssensor umfasst folgende Schritte:
- Bereitstellen einer Antriebsaufnahme,
- Anordnen eines Piezostapelantriebs in der Antriebsaufnahme,
- Festziehen einer Spanneinrichtung zum Verspannen des Piezostapelantriebs mit der Antriebsaufnahme mit einem ersten vorgegebenen Drehmoment,
- Tempern der piezoelektrischen Sende- und/oder Empfangseinrichtung und
- Nachziehen der Spanneinrichtung mit einem zweiten vorgegebenen Drehmoment.

Durch das erfindungsgemäße Verfahren wird es ermöglicht, dass die piezoelektrische Sende- und/oder Empfangseinrichtung vollständig vormontiert, vorgespannt, getempert und nachgezogen werden kann, ohne dass diese in dem Sensor verbaut sein muss. Das Tempern soll insbesondere bei einer Temperatur unterhalb der Curie-Temperatur der verwendeten Piezomaterialien aber wenigstens bei einer Temperatur von 300°C für eine Zeitdauer von wenigstens 4 Stunden erfolgen, sodass sich der Antrieb ausreichend setzt und anschließend nachgezogen werden kann.

Eine Vorspannung des Antriebs kann beispielsweise mit einem ersten Drehmoment zwischen 1,5 Nm und 2,5 Nm, vorzugsweise von 2 Nm und/oder das Nachziehen mit einem zweiten Drehmoment zwischen 1,5 Nm und 2,5 Nm, vorzugsweise 2 Nm erfolgen.

Durch diese Drehmomente wird eine hinreichend gute Vorspannung des Antriebs erreicht, sodass diese sofort nach dem Einsetzen in einen Sensor, d. h. nach dem Verbinden der piezoelektrischen Sende- und/oder Empfangseinrichtung mit der Membran, auf die diese wirkt, eingesetzt werden kann.

Im Gegensatz zu den aus dem Stand der Technik bekannten piezoelektrischen Sende- und/oder Empfangseinrichtungen für Vibrationssensoren arbeiten die Antriebe gemäß der vorliegenden Anmeldung auf Druck, d. h. dass über die Druckstücke 19 eine Kraftwirkung aus dem Piezostapelantrieb 11 zentral in die Membran 90 eingeleitet und diese aus Sensorsicht in Axialrichtung nach außen verformt wird, wohingegen im Stand der Technik eine Krafteinleitung aus dem Piezostapelantrieb in die Membran über den an die Membran angeformten Zugbolzenaufzug erfolgt.

Die vorliegende Erfindung wird nachfolgend anhand von Ausführungsbeispielen unter Bezugnahme auf die beigefügten Figuren eingehend erläutert. Es zeigen:
- Fig. 1: eine schematische Darstellung eines ersten Ausführungsbeispiels eines Vibrationssensors gemäß der vor liegenden Anmeldung,
- Fig. 2: ein zweites Ausführungsbeispiel eines Vibrationssensors gemäß der vorliegenden Anmeldung,
- Fig. 3: ein drittes Ausführungsbeispiel eines Vibrationssensors 100 gemäß der vorliegenden Anmeldung und
- Fig. 4: eine schematische Darstellung eines Vibrationssensors gemäß dem Stand der Technik (schon behandelt) und
- Fig. 5: ein Herstellungsverfahren für eine piezoelektrische Sende- und/oder Empfangseinheit.

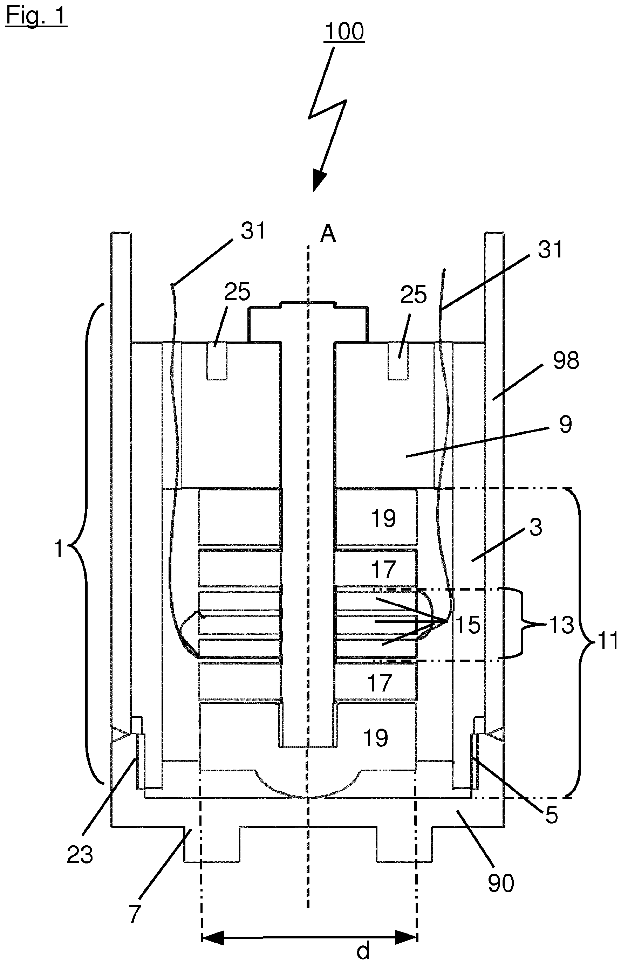

Figur 1 zeigt eine schematische Darstellung eines Vibrationssensors 100, bei dem in einem Sensorgehäuse 98, das rückseitig an einer schwingfähig gelagerten Membran 90, an der vorderseitig eine mechanische Schwingungseinheit 7 angeordnet ist, eine piezoelektrische Sende- und/oder Empfangseinrichtung angeordnet ist.

Die piezoelektrische Sende- und/oder Empfangseinrichtung 1, nachfolgend auch Antrieb genannt, ist aus einer im Wesentlichen becherförmig ausgebildeten Antriebsaufnahme 3 gebildet, in der ein Piezostapelantrieb 11 angeordnet ist. Der Piezostapelantrieb 11 ist mit einem Befestigungsabschnitt 9 der Antriebsaufnahme 3 verspannt, wobei der Befestigungsabschnitt 9 den Boden der becherförmig ausgebildeten Antriebsaufnahme bildet und mit einer ausreichend große Dicke ausgebildet ist, um eine Kraftwirkung des Piezostapelantriebs 11 ohne Verformung des Befestigungsabschnitts 9 aufzunehmen.

Der Piezostapelantrieb 11 ist im vorliegenden Ausführungsbeispiel aus einer Piezoeinheit 13, oberhalb und unterhalb der Piezoeinheit 13 angeordneten Anpasskeramiken 17 sowie oberhalb und unterhalb der Anpasskeramiken 17 im Stapel angeordneten Druckstücken 19 gebildet. Die Piezoeinheit 13 weist im vorliegenden Ausführungsbeispiel drei Piezoelemente 15 auf, die über zwischen den Piezoelementen 15 sowie ober- und unterhalb der Piezoelemente 15 angeordnete Elektroden 16 (vorliegend nicht dargestellt), die über Anschlussleitungen 31 kontaktiert werden, gebildet.
Durch Anlegen einer Spannung an die Anschlussleitungen 31 sind die Piezoelemente 15 der Piezoeinheit 13 anregbar.

Die Anpasskeramiken 17, die oberhalb und unterhalb der Piezoeinheit 11 angeordnet sind, dienen zur Anpassung eines thermischen Ausdehnungskoeffizienten der Piezoelemente 15 an die oberhalb bzw. unterhalb der Anpasskeramiken 17 angeordneten Druckstücke 19. Die Druckstücke 19 dienen zur vollflächigen Aufnahme und Weitergabe einer in der Piezoeinheit 13 durch Anlegen der Spannung hervorgerufenen Kraftwirkung in Axialrichtung A des Piezostapelantriebs 11. Das membranseitig angeordnete Druckstück 19 weist im vorliegenden Ausführungsbeispiel ein Innengewinde auf, in das eine Spannschraube 21 zum Verspannen des Piezostapelantriebs mit dem Befestigungsabschnitt 9 eingreift. Alternativ kann das Druckstück 19 auch einen einstückig angeformten Bolzen aufweisen, der sich durch die weiteren Komponenten des Piezostapelantriebs 11 in Richtung des Befestigungsabschnitts 9 erstreckt und mit diesem verspannt wird.

In dem in Figur 1 dargestellten Ausführungsbeispiel sind die Piezoelemente 15, die Anpasskeramiken 17 sowie das obere, dem Befestigungsabschnitt 9 zugewandte Druckstück 19 jeweils ringförmig ausgebildet, sodass die Spannschraube 21 in Axialrichtung A zentrisch durch diese Elemente hindurchgeführt sein kann. Die Kontaktierung der Piezoelemente 15 der Piezoeinheit 13 erfolgt am Umfang der Piezoelemente, wobei die Anschlussleitungen 31 außenseitig an dem Piezostapelantrieb entlang geführt sind und durch zwei Öffnungen in dem Befestigungsabschnitt 9 rückseitig aus der piezoelektrischen Sende- und/oder Empfangseinrichtung 1 geführt sind.

Die Antriebsaufnahme 3 weist vorderseitig, d. h. an einem in der vorliegenden Darstellung membranseitigen Ende ein Außengewinde auf, das mit einem Innengewinde zusammenwirkt, das an einem an die Membran 90 angeformten und sich in rückseitige Richtung erstreckenden als umlaufender Steg ausgebildeten zweiten mechanischen Verbindungsabschnitt 23 eingebracht ist. Auf diese Weise kann die piezoelektrische Sende- und/oder Empfangseinrichtung 1 derart kraftschlüssig mit der Membran 90 verbunden werden, dass eine durch Anlegen einer Spannung an die Piezoelemente 15 hervorgerufene Ausdehnung des Piezostapelantriebs 11 in Axialrichtung A zu einer Verformung der Membran 90 in Axialrichtung A führt.

Um eine Krafteinleitung in die Membran 90 zu begünstigen und um eine möglichst zentrische Krafteinleitung zu gewährleisten, weist das membranseitige Druckstück 19 der piezoelektrischen Sende- und/oder Empfangseinrichtung eine in Radialrichtung zentrisch angeordnete kalottenförmige Anformung auf, die sich in Axialrichtung A erstreckt und über die die Krafteinleitung in die Membran 90 erfolgt.

Das Sensorgehäuse 98 ist im vorliegenden Ausführungsbeispiel im Vergleich zu dem zweiten mechanischen Verbindungsabschnitt 23 deutlich dünner und damit weniger stabil ausgebildet und mit diesem über eine umlaufende Schweißnaht verbunden. Das Gehäuse kann somit beispielsweise aus einem gerundeten Blech gefertigt sein und somit deutlich kostengünstiger ausgestaltet sein.

Um einen ordnungsgemäßen Betrieb des Vibrationssensors 100 zu gewährleisten ist die piezoelektrische Sende- und/oder Empfangseinrichtung mit einem vorgegebenen Drehmoment in dem Sensorgehäuse 98 an der Membran 90 befestigt. Um ein Lockern des so eingeschraubten Antriebs 1 zu verhindern, ist dieser mit Schraubensicherungslack zusätzlich zur Verschraubung fixiert. Um eine gute Übertragung des notwendigen Drehmoments auf die Antriebsaufnahme 3 zu gewährleisten, ist diese rückseitig mit Ausnehmungen 25 versehen, in die ein geeignetes Einschraubwerkzeug eingesetzt und somit das Drehmoment übertragen werden kann.

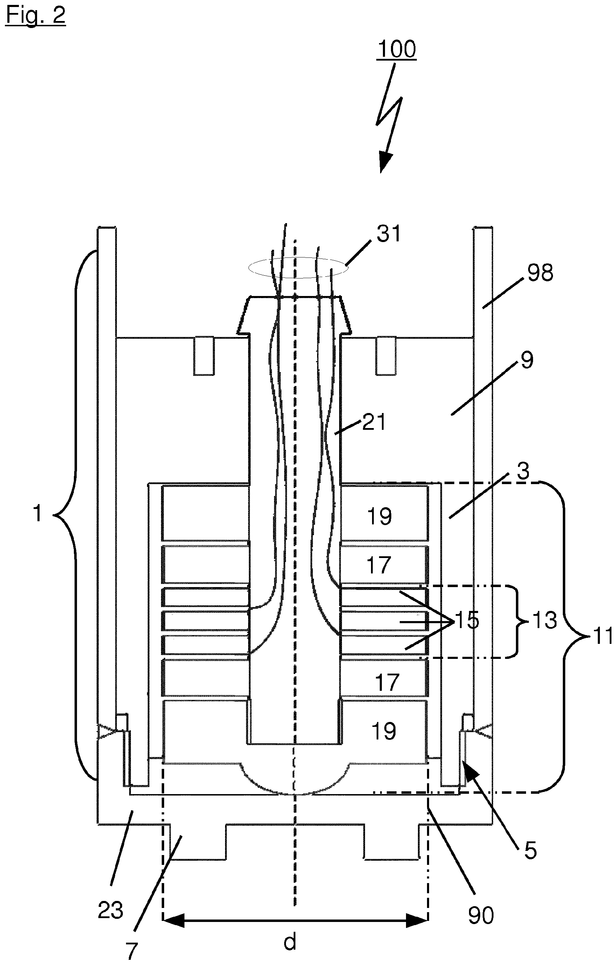

In Figur 2 ist ein weiteres Ausführungsbeispiel eines Vibrationssensors 100 gemäß der vorliegenden Anmeldung gezeigt. Der Vibrationssensor 100 weist im Wesentlichen den Aufbau des in Bezug auf Figur 1 beschriebenen Vibrationssensors 100 auf, wobei im Unterschied zu dem Ausführungsbeispiel gemäß Figur 1 bei dem Ausführungsbeispiel gemäß Figur 2 die Anschlussleitung 31 zur Kontaktierung der Piezoelemente 15 der Piezoeinheit 13 nicht außenseitig an dem Piezostapelantrieb 11 entlang geführt sind, sondern im Inneren einer hohl ausgeführten Spanneinrichtung 21, die zentrisch durch die Elemente des Piezostapelantriebs 11 geführt ist, verlaufen. Durch diese innenliegende Führung der Anschlussleitungen 31 wird es ermöglicht, die Komponenten des Piezostapelantriebs 11 im Vergleich zur Ausführungsform gemäß Figur 1 mit einem größeren Durchmesser d auszugestalten. Im Gegenzug ist es notwendig, dass eine Öffnung durch die die Spannung 21 geführt ist, mit einem etwas größeren Durchmesser auszugestalten. Auf diese Weise kann aber dennoch eine Maximierung der Fläche des Kreisrings und damit eine Maximierung der erzielbaren Kraftwirkung des Piezostapelantriebs erreicht werden.

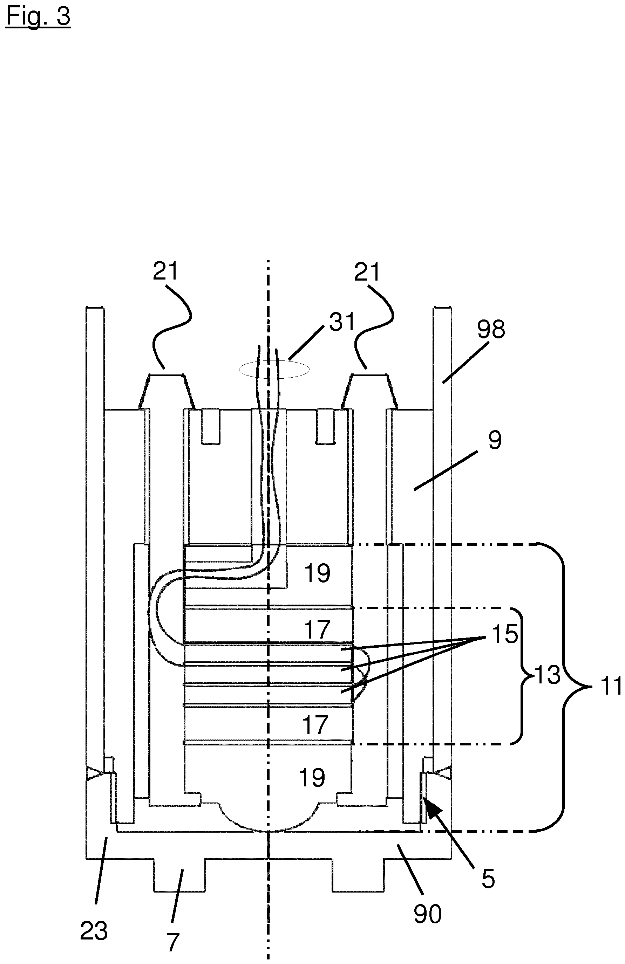

In einer weiteren Ausgestaltungsform, die in Figur 3 dargestellt ist, sind die Elemente des Piezostapelantriebs 11 als Kreisscheiben ausgestaltet, wobei eine Vorspannung des Piezostapelantriebs 11 über zwei außenseitig an dem Stapel geführte und am Umfang des membranseitig angeordneten Druckstücks 19 angreifende Spanneinrichtungen 21 erfolgt. Diese Ausgestaltung kann beispielsweise gewählt werden, wenn ein Aufbau des Piezostapelantriebs 11 mit ringförmigen Piezoelementen 15 nicht gewünscht ist.

Alternativ zu der in den Figuren 1 bis 3 dargestellten Verbindung der Piezoelektrischen Sende- und/oder Empfangseinrichtung über ein an der Antriebsaufnahme 3 angeordnetes Außengewinde 5, das mit einem an der Membran 90 bzw. an dem daran angeordneten zweiten mechanischen Verbindungsabschnitt 23 angeordneten Innengewinde zusammenwirkt, könnte die piezoelektrische Sende- und/oder Empfangseinrichtung auch durch ein Verpressen der Antriebsaufnahme 3 mit dem zweiten mechanischen Verbindungsabschnitt 23 erreicht werden.

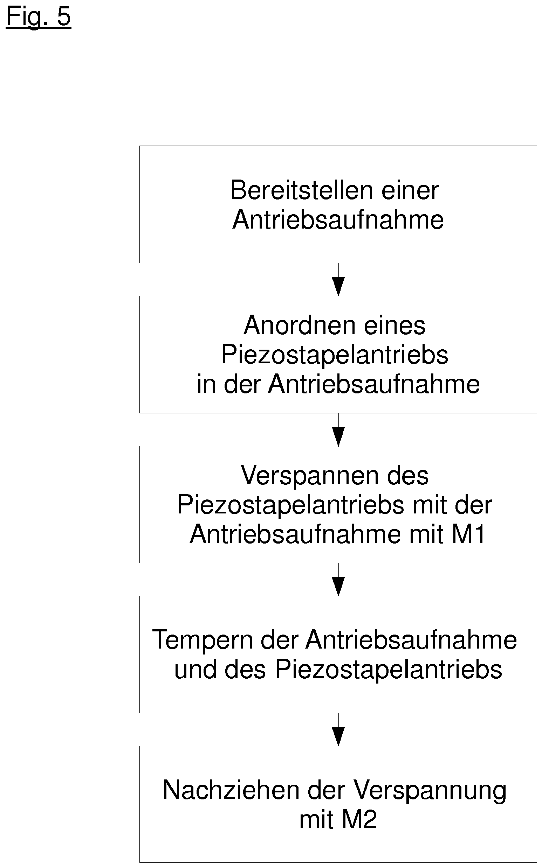

Ein Verfahren zur Herstellung eine piezoelektrischen Sende- und/oder Empfangseinrichtung gemäß der vorliegenden Anmeldung ist in Figur 5 dargestellt.

Figur 5 zeigt einen beispielhaften Ablauf für ein Herstellungsverfahren gemäß der vorliegenden Anmeldung.

In einem ersten Schritt wird eine Antriebsaufnahme 3 bereitgestellt, die geeignet ausgebildet ist, über einen Verbindungsabschnitt 5 mit der Membran 90 eines Vibrationssensors 100 verbunden zu werden. In die Antriebsaufnahme 3 wird anschließend ein Piezostapelantrieb 11 - sei es in Einzelteilen oder als zu einem Monoblock gesinterte Einheit - eingesetzt und in einem weiteren Schritt mit der Antriebsaufnahme 3 verspannt. Das Verspannen erfolgt mit einem ersten vorgegebenen Drehmoment M1. Anschließend wird die so vormontierte piezoelektrische Sende- und/oder Empfangseinrichtung 100 getempert, d.h. bei einer vorgegebenen Temperatur, bspw. bei 300°C für eine Dauer von 4 Stunden gelagert und daran anschließend nachgezogen, d.h. dass die Verspannung mit einem zweiten Drehmoment M2, das auch zu dem ersten Drehmoment M1 identisch sein kann, nachgezogen wird. Dadurch, dass sich die Komponenten der piezoelektrischen Sende- und/oder Empfangseinrichtung 100 durch den Temperschritt gesetzt haben, kann davon ausgegangen werden, dass derartige Vorgänge in erheblichem Umfang nicht weiter auftreten und damit der Antrieb betriebsfertig vormontiert ist.

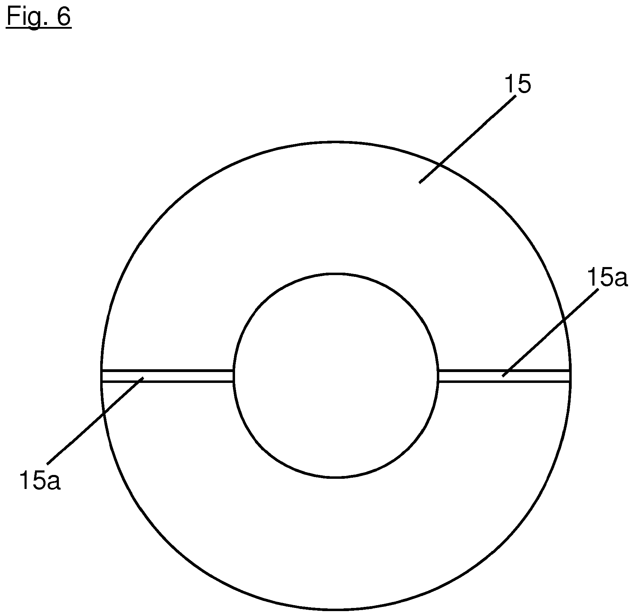

Figur 6 zeigt ein als Ringscheibe ausgebildetes Piezoelement 15, das an radial gegenüberliegenden Seiten auf der einen Seite eine oberseitig und auf der radial gegenüberliegenden Seite eine unterseitig in das Piezoelement 15 eingebrachte Nut 15a aufweist. Die Piezoelemente 15 können zur Erzeugung einer Piezoeinheit 13 eine Piezostapelantriebs 11 zusammen mit den Anschlussleitungen 31 zu einem Monoblock gesintert sein.

### Bezugszeichenliste

- 1: Piezoelektrisches Sende- und/oder Empfangseinrichtung
- 3: Antriebsaufnahme
- 5: mech. Verbindungsabschnitt/Außengewinde
- 7: mech. Schwingungseinheit
- 9: Befestigungsabschnitt
- 11: Piezostapelantrieb
- 13: Piezoeinheit
- 15: Piezoelement
- 16: Elektroden
- 17: Anpasskeramik
- 19: Druckstück
- 21: Spannschraube / Nut
- 23: zweiter mech. Verbindungsabschnitt
- 25: Ausnehmungen
- 31: Anschlussleitung
- 89: Hülse
- 90: Membran
- 91: Spannbolzen
- 92: Spannmutter
- 98: Sensorgehäuse
- 100: Vibrationssensor
- A: Axialrichtung
- D: Durchmesser
- M₁: Erstes Drehmoment
- M₂: Zweites Drehmoment

## Patentansprüche

1. Piezoelektrische Sende- und/oder Empfangseinrichtung (1) für einen Vibrationssensor (100)
**dadurch gekennzeichnet, dass** die piezoelektrische Sende- und/oder Empfangseinrichtung (1) als separat handhabbare Einheit mit einer Antriebsaufnahme (3) mit einem mechanischen Verbindungsabschnitt (5) zum Verbinden der piezoelektrischen Sende- und/oder Empfangseinrichtung (1) mit einer Membran (90) des Vibrationssensors (100) ausgebildet ist, einen Piezostapelantieb (11) aufweist, wobei ,
die Antriebsaufnahme (3) einen Befestigungsabschnitt (9) zum Befestigen und Vorspannen des Piezostapelantriebs (11) in der Antriebsaufnahme (3) aufweist und der Piezostapelantrieb (11) mit der Antriebsaufnahme (3) verspannt ist.

2. Piezoelektrische Sende- und/oder Empfangseinrichtung (1) gemäß Anspruch 1,
**dadurch gekennzeichnet, dass**
der Piezostapelantrieb (11) einen Stapel mit einer Piezoeinheit (13) mit wenigstens einem Piezoelement (15) sowie im Stapel oberhalb und unterhalb der Piezoeinheit (13) jeweils eine Anpasskeramik (17) aufweist.

3. Piezoelektrische Sende- und/oder Empfangseinrichtung (1) gemäß Anspruch 2,
**dadurch gekennzeichnet, dass**
in dem Stapel ober- und unterhalb der Anpasskeramik (17) jeweils ein vorzugsweise metallisches Druckstück (19) angeordnet ist.

4. Piezoelektrische Sende- und/oder Empfangseinrichtung (1) gemäß Anspruch 3,
**dadurch gekennzeichnet, dass**
die Druckstücke (19), die Anpasskeramiken (17) sowie das wenigstens eine Piezoelement (15) mit kreisförmiger Außenkontur ausgebildet sind und einen identischen Durchmesser (d) aufweisen.

5. Piezoelektrische Sende- und/oder Empfangseinrichtung (1) gemäß einem der Ansprüche 2 bis 4,
**dadurch gekennzeichnet, dass**
der Piezostapelantrieb (11) zu einem Monoblock gesintert ist.

6. Piezoelektrische Sende- und/oder Empfangseinrichtung (1) gemäß Anspruch 5,
**dadurch gekennzeichnet, dass**
die Piezoelemente (15) jeweils eine Nut (21) aufweisen, in der eine Anschlussleitung (31) zur Kontaktierung der Piezoelemente (15) angeordnet ist.

7. Vibrationssensor (100) mit einer an einer in Schwingung versetzbaren Membran (90) angeordneten mechanischen Schwingungseinheit (7) und einem zweiten Verbindungsabschnitt (5) zum Verbinden der Membran (90) mit einer piezoelektrischen Sende- und/oder Empfangseinrichtung (1) derart, dass Schwingungen der piezoelektrischen Sende- und/oder Empfangseinrichtung (1) auf die Membran (90) und Schwingungen der Membran (90) auf die piezoelektrische Sende- und/oder Empfangseinrichtung (1) übertragen werden,
**dadurch gekennzeichnet, dass**
die piezoelektrische Sende- und/oder Empfangseinrichtung (1) als separat handhabbare Einheit gemäß einem der vorhergehenden Ansprüche ausgebildet ist.

8. Verfahren zum Herstellen einer piezoelektrischen Sende- und/oder Empfangseinrichtung (1) gemäß Anspruch 1 für einen Vibrationssensor (100) mit folgenden Schritten:
- Bereitstellen einer Antriebsaufnahme (3),
- Anordnen eines Piezostapelantriebs (11) in der Antriebsaufnahme (3), das Verfahren charakterisiert durch
- Festziehen einer Spanneinrichtung (60) zur Verspannung des Piezostapelantriebs (11) mit der Antriebsaufnahme (3) mit einem ersten vorgegebenen Drehmoment (M₁),
- Tempern der piezoelektrischen Sende- und/oder Empfangseinrichtung (1),
- Nachziehen der Spanneinrichtung (60) mit einem zweiten vorgegebenen Drehmoment (M₂).

9. Verfahren gemäß Anspruch 8,
**dadurch gekennzeichnet, dass**
das Tempern bei einer Temperatur unterhalb der Curie-Temperatur verwendeter Piezomaterialien aber wenigstens von 300°C für wenigstens 4 Stunden erfolgt.

10. Verfahren gemäß einem der Ansprüche 8 oder 9,
**dadurch gekennzeichnet, dass**
das erste Drehmoment (M₁) zwischen 1,5 Nm und 2,5 Nm, vorzugsweise 2 Nm beträgt und/oder das zweite Drehmoment (M2) zwischen 1,5 Nm und 2,5 Nm, vorzugsweise 2 Nm beträgt.

## Claims

1. A piezoelectric transmitting and/or receiving device (1) for a vibration sensor (100),
**characterized in that**
the piezoelectric transmitting and/or receiving device (1) is configured as a unit that can be handled separately, with a drive seat (3) with a mechanical connection section (5) for connecting the piezoelectric transmitting and/or receiving device (1) to a diaphragm (90) of the vibration sensor (100), has a piezo-stack drive (11), wherein
the drive seat (3) has a fastening section (9) for fastening and biasing the piezo-stack drive (11) in the drive seat (3), and the piezo-stack drive (11) is clamped to the drive seat (3).

2. The piezoelectric transmitting and/or receiving device (1) according to claim 1,
**characterized in that**
the piezo-stack drive (11) has a stack with a piezo unit (13) with at least one piezo element (15) and one ceramic adjusting member (17), respectively, above and below the piezo unit (13) in the stack.

3. The piezoelectric transmitting and/or receiving device (1) according to claim 2,
**characterized in that**
in the stack, one, preferably metallic, thrust member (19) is disposed in each case above and below the ceramic adjusting member (17).

4. The piezoelectric transmitting and/or receiving device (1) according to claim 3,
**characterized in that**
the thrust members (19), the ceramic adjusting members (17) and the at least one piezo element (15) are formed with a circular outer contour and have an identical diameter (d).

5. The piezoelectric transmitting and/or receiving device (1) according to any one of the claims 2 to 4,
**characterized in that**
the piezo-stack drive (11) is sintered to form a monoblock.

6. The piezoelectric transmitting and/or receiving device (1) according to claim 5,
**characterized in that**
the piezo elements (15) each have a groove (21) in which a connecting line (31) for contacting the piezo elements (15) is disposed.

7. A vibration sensor (100) with a mechanical oscillation unit (7) disposed on a diaphragm (90) that can be made to oscillate, and a second connection section (5) for connecting the diaphragm (90) to a piezoelectric transmitting and/or receiving device (1) in such a way that oscillations of the piezoelectric transmitting and/or receiving device (1) are transferred on to the diaphragm (90) and oscillations of the diaphragm (90) on to the piezoelectric transmitting and/or receiving device (1),
**characterized in that**
the piezoelectric transmitting and/or receiving device (1) is configured as a unit that can be handled separately according to any one of the preceding claims.

8. A method for producing a piezoelectric transmitting and/or receiving device (1) according to claim 1 for a vibration sensor (100), comprising the following steps:
- providing a drive seat (3),
- disposing a piezo-stack drive (11) in the drive seat (3), the method being **characterized by**
- tightening a clamping device (60) for clamping the piezo-stack drive (11) to the drive seat (3) with a first predetermined torque (M₁),
- tempering the piezoelectric transmitting and/or receiving device (1),
- re-tightening the clamping device (60) with a second predetermined torque (M₂).

9. The method according to claim 8,
**characterized in that**
tempering is carried out at a temperature below the Curie temperature of the piezo materials used, but at at least 300°C, for at least 4 hours.

10. The method according to any one of the claims 8 or 9,
**characterized in that**
the first torque (M₁) is between 1.5 Nm and 2.5 Nm, preferably 2 Nm, and/or the second torque (M2) is between 1.5 Nm and 2.5 Nm, preferably 2 Nm.

## Revendications

1. Dispositif piézoélectrique d'émission et/ou de réception (1) pour un capteur de vibrations (100), **caractérisé par le fait que** le dispositif piézoélectrique d'émission et/ou de réception (1) est conçu en tant qu'unité apte à être maniée séparément et ayant un logement d'entraînement (3) avec une section de liaison mécanique (5) pour relier le dispositif piézoélectrique d'émission et/ou de réception (1) à une membrane (90) du capteur de vibrations (100), comprend un entraînement de pile piézoélectrique (11), dans lequel le logement d'entraînement (3) comprend une section de fixation (9) pour fixer et précontraindre l'entraînement de pile piézoélectrique (11) dans le logement d'entraînement (3), et l'entraînement de pile piézoélectrique (11) est serré avec le logement d'entraînement (3).

2. Dispositif piézoélectrique d'émission et/ou de réception (1) selon la revendication 1, **caractérisé par le fait que** l'entraînement de pile piézoélectrique (11) comprend une pile ayant une unité piézoélectrique (13) avec au moins un élément piézoélectrique (15) ainsi que, dans la pile, respectivement une céramique d'adaptation (17) au-dessus et au-dessous de l'unité piézoélectrique (13).

3. Dispositif piézoélectrique d'émission et/ou de réception (1) selon la revendication 2, **caractérisé par le fait que** respectivement une pièce de pression (19) de préférence métallique est disposée dans la pile au-dessus et au-dessous de la céramique d'adaptation (17).

4. Dispositif piézoélectrique d'émission et/ou de réception (1) selon la revendication 3, **caractérisé par le fait que** les pièces de pression (19), les céramiques d'adaptation (17) et ledit au moins un élément piézoélectrique (15) sont conçus de manière à avoir un contour extérieur circulaire et présentent un diamètre (d) identique.

5. Dispositif piézoélectrique d'émission et/ou de réception (1) selon l'une quelconque des revendications 2 à 4, **caractérisé par le fait que** l'entraînement de pile piézoélectrique (11) est fritté pour former un monobloc.

6. Dispositif piézoélectrique d'émission et/ou de réception (1) selon la revendication 5, **caractérisé par le fait que** les éléments piézoélectriques (15) présentent chacun une rainure (21) dans laquelle est disposée une ligne de connexion (31) pour la mise en contact des éléments piézoélectriques (15).

7. Capteur de vibrations (100) comprenant une unité de vibration mécanique (7) qui est disposée sur une membrane (90) apte à être mise en vibration ainsi qu'une deuxième section de liaison (5) pour relier la membrane (90) à un dispositif piézoélectrique d'émission et/ou de réception (1) de telle manière que des vibrations du dispositif piézoélectrique d'émission et/ou de réception (1) sont transmises à la membrane (90) et des vibrations de la membrane (90) sont transmises au dispositif piézoélectrique d'émission et/ou de réception (1), **caractérisé par le fait que** le dispositif piézoélectrique d'émission et/ou de réception (1) est conçu en tant qu'unité apte à être maniée séparément, selon l'une quelconque des revendications précédentes.

8. Procédé de fabrication d'un dispositif piézoélectrique d'émission et/ou de réception (1) selon la revendication 1, pour un capteur de vibrations (100), comprenant les étapes suivantes consistant à:
- fournir un logement d'entraînement (3),
- disposer un entraînement de pile piézoélectrique (11) dans ledit logement d'entraînement (3),
le procédé étant **caractérisé par**
- serrer un dispositif de serrage (60) destiné à serrer, avec un premier couple (M1) prédéterminé, l'entraînement de pile piézoélectrique (11) avec le logement d'entraînement (3),
- recuire le dispositif piézoélectrique d'émission et/ou de réception (1),
- resserrer le dispositif de serrage (60) avec un deuxième couple (M2) prédéterminé.

9. Procédé selon la revendication 8, **caractérisé par le fait que** le recuit est mis en œuvre à une température inférieure à la température de Curie des matériaux piézoélectriques utilisés, mais d'au moins 300 °C, pendant au moins 4 heures.

10. Procédé selon l'une quelconque des revendications 8 ou 9, **caractérisé par le fait que** le premier couple (M1) est compris entre 1,5 Nm et 2,5 Nm, de préférence il est de 2 Nm et/ou le deuxième couple (M2) est compris entre 1,5 Nm et 2,5 Nm, de préférence il est de 2 Nm.
